# EUROPEAN PATENT APPLICATION

(11) **EP 2 403 325 A1**
(43) Date of publication of application: **04.01.2012**
(21) Application number: 10746157.6
(22) Date of filing: 22.02.2010
(51) Int. Cl.: H05K 3/28, G02F 1/13357, H05K 1/02, H05K 1/05

(54) **WIRING BOARD, ELECTRONIC DEVICE PACKAGE, AND METHODS OF PRODUCTION OF THE SAME**

(30) Priority: 24.02.2009 JP 2009040734; 04.02.2010 JP 2010023015
(71) Applicant: Hitachi Chemical Company, Ltd., Tokyo 163-0449 (JP)
(72) Inventor: YOSHIDA Hideki, Ishioka-shi Ibaraki 315-0002 (JP); ISODA Satoshi, Ishioka-shi Ibaraki 315-0002 (JP); URASAKI Naoyuki, Tsukuba-shi Ibaraki 300-4247 (JP); KOTANI Hayato, Tsukuba-shi Ibaraki 300-4247 (JP)
(74) Representative: von Kreisler Selting Werner
(86) International application number: PCT/JP2010/052611
(87) International publication number: WO 2010/098276

(57) **Abstract**

A wiring board which uses both conductor patterns and reflection members provided at gaps therebetween to suppress unevenness in the reflection rate so as to raise the overall reflection rate and provide a reflection function on the surface of the wiring board at the side where an electronic device is mounted; facilitates shaping of the reflection members, controlling of the thickness of the reflection members, and controlling of the surface shape of the reflection members so as to stabilize the reflection rate; and secures close contact between the reflection members and sealing members so as to improve reliability. The wiring board comprises a plurality of wiring layers provided with conductor patterns disposed on base members, and base members which electrically insulate the plurality of wiring layers. At the outermost wiring layer among the plurality of wiring layers, reflection members are formed on the portions of the base member where there are no conductor patterns, the surface of these reflection members and the surface of the conductor patterns are made level and the surface of the conductor patterns are exposed from the reflection members.

## Description

### Technical Field

The present invention relates to a wiring board having a reflection function, an electronic device package using the wiring board, and methods of production of the same.

### Background Art

With regard to a wiring board on which an electronic device is mounted, a wiring board having a reflection function and a module, a flat display, and the like including the wiring board have been proposed.

For such a structure, for example, it has been proposed that: a reflection function is imparted to a wiring board by providing a nickel-plated portion, the nickel being a silver-white metal; and a bonding function is also imparted thereto by providing a gold-plated portion to thereby form a pad for wire bonding connection (Patent Literature 1).

Further, it has been proposed that both of a reflection function and a wiring board function are imparted to a wiring board by forming a reflection layer on one surface of the wiring board and mounting an electronic device on another surface thereof, whereby a reduction in thickness of a light emitting module or a flat display is achieved (Patent Literature 2). Still further, it has been proposed that a reflection function is imparted to a wiring board by providing a circuit on a metal plate via an insulating layer and providing white solder resist on the insulating layer (Patent Literature 3).

### Citation List

### Patent Literature

Patent Literature 1: Japanese Patent Laid-Open Publication No. 2003-031914
Patent Literature 2: Japanese Patent Laid-Open Publication No. 2005-062579
Patent Literature 3: Japanese Patent Laid-Open Publication No. 2009-004718

### Summary of Invention

### Technical Problem

However, according to Cited Literature 1, although the plated portion has the reflection function, a non-plated gap portion between conductor patterns does not have the reflection function. Therefore, unevenness in reflection rate occurs, so that it is difficult to improve the reflection rate of the entire wiring board. According to Cited Literature 2, because the surface of the wiring board on which the electronic device is mounted does not have the reflection function, it is not possible to deal with a case where the reflection function is required for the surface on which the electronic device is mounted. According to Cited Literature 3, because the white solder resist is formed on a copper circuit other than a portion thereof on which the electronic device is mounted, it is necessary to provide a fine opening in the copper circuit, but formation of a fine pattern is difficult by printing. Even if a photo method is used, the formation of the fine opening pattern is still difficult because the white solder resist is poorly transmissive to light to which the pattern is to be exposed. In addition, the white solder resist is applied in the form of ink, and an application thickness and a surface shape therefore vary depending on viscosity, application conditions, and the like, so that stabilization of the reflection rate is difficult. Further, a surface of the white solder resist is smooth, and hence when a sealing member is molded to the surface, close contact between the white solder resist and the sealing member is difficult to secure.

The present invention has been made in view of the above-mentioned problems, and therefore has an object to provide a wiring board, an electronic device package, and methods of production of the same in which: both conductor patterns and a reflection member provided at a gap therebetween are used to suppress unevenness in reflection rate so as to improve the overall reflection rate, and a reflection function can thus be provided to a surface of the wiring board on which an electronic device is mounted; shaping of the reflection member, controlling of a thickness of the reflection member, and controlling of a surface shape of the reflection member are facilitated so as to stabilize the reflection rate; and close contact between the reflection member and a sealing member is secured so as to improve reliability.

### Solution to Problem

The present invention relates the following items.
(1) A wiring board, including: a plurality of wiring layers each including a conductor pattern provided on a base member; and the base member which electrically insulates the plurality of wiring layers, in which: the wiring board further includes a reflection member which is formed on a portion of the base member in which the conductor pattern is not provided, in an outermost wiring layer among the plurality of wiring layers; a surface of the reflection member and a surface of the conductor pattern are made level with each other; and the surface of the conductor pattern is exposed from the reflection member.
(2) The wiring board according to Item (1), in which: the conductor pattern includes: an electrode for mounting an electronic device thereon; and a frame-like conductor which surrounds the electrode; the reflection member is formed on the portion of the base member in which the conductor pattern is not provided so as to fill a gap between the conductor patterns, inside of the frame-like conductor; the surface of the reflection member and the surface of the conductor pattern are made level with each other; and the surface of the conductor pattern is exposed from the reflection member.
(3) The wiring board according to Item (1) or (2), in which the conductor pattern and the reflection member are collectively polished after the reflection member is formed on the portion of the base member in which the conductor pattern is not provided, to thereby make the surface of the reflection member and the surface of the conductor pattern level with each other and expose the surface of the conductor pattern on the reflection member.
(4) The wiring board according to Item (1) or (2), in which the reflection member is a resin composition containing a heat-curable resin and a white pigment.
(5) The wiring board according to Item (1) or (2), in which a thickness of the reflection member is 10 µm to 50 µm.
(6) The wiring board according to Item (1) or (2), further including a reflection layer which is formed by gold plating or silver plating on the conductor pattern.
(7) The wiring board according to Item (1) or (2), in which both of the conductor pattern and the reflection member have a reflection rate of 70% or higher with respect to light having any wavelength between 420 ± 10 nm and 800 ± 10 nm.
(8) The wiring board according to Item (1) or (2), in which the surface of the reflection member includes irregularities of 0.3 µm to 7 µm in terms of an average roughness Ra.
(9) The wiring board according to Item (1) or (2), further including a concave part opened upward which is provided in the reflection member of the outermost wiring layer.
(10) An electronic device package, which is formed by: using the wiring board according to Item (1) or (2); mounting an electronic device on an electrode formed in a conductor pattern; and sealing the electrode and the electronic device with a sealing member.
(11) A method of production of a wiring board, including the steps of: forming a conductor pattern in an outermost wiring layer among a plurality of wiring layers, the conductor pattern including: an electrode for mounting an electronic device thereon; and a frame-like conductor which surrounds the electrode; forming a reflection member on a portion of a base member in which the conductor pattern is not provided so as to fill a gap between the conductor patterns; and collectively polishing the conductor pattern and the reflection member, to thereby make a surface of the reflection member and a surface of the conductor pattern level with each other and expose the surface of the conductor pattern on the reflection member.
(12) The method of production of the wiring board according to Item (11), further including the step of forming a concave part opened upward in the reflection member.
(13) A method of production of an electronic device package, including the steps of: forming a conductor pattern in an outermost wiring layer among a plurality of wiring layers, the conductor pattern including: an electrode for mounting an electronic device thereon; and a frame-like conductor which surrounds the electrode; forming a reflection member on a portion of a base member in which the conductor pattern is not provided so as to fill a gap between the conductor patterns; collectively polishing the conductor pattern and the reflection member, to thereby make a surface of the reflection member and a surface of the conductor pattern level with each other and expose the surface of the conductor pattern on the reflection member; and mounting the electronic device on the electrode of the conductor pattern and sealing the conductor pattern and the electronic device with a sealing member.
(14) The method of production of the electronic device package according to Item (13), further including, after the step of collectively polishing the conductor pattern and the reflection member, to thereby make the surface of the reflection member and the surface of the conductor pattern level with each other and expose the surface of the conductor pattern on the reflection member, the steps of: forming a concave part opened upward in the reflection member; and mounting the electronic device on the electrode of the conductor pattern and sealing the conductor pattern and the electronic device with the sealing member.

### Advantageous Effects of Invention

According to the present invention, it becomes possible to provide a wiring board, an electronic device package, and methods of production of the same in which: both conductor patterns and a reflection member provided at a gap therebetween are used to suppress unevenness in reflection rate so as to improve the overall reflection rate, and a reflection function can thus be provided to a surface of the wiring board on which an electronic device is mounted; shaping of the reflection member, controlling of a thickness of the reflection member, and controlling of a surface shape of the reflection member are facilitated so as to stabilize the reflection rate; and close contact between the reflection member and a sealing member is secured so as to improve reliability.

### Brief Description of Drawings

[Figure 1]

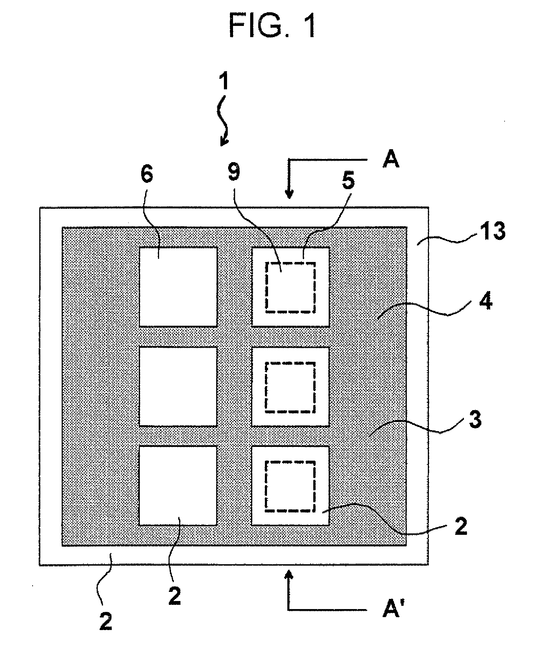

   Figure 1 is a plan view of a wiring board according to Examples 1 to 10 of the present invention.
[Figure 2]

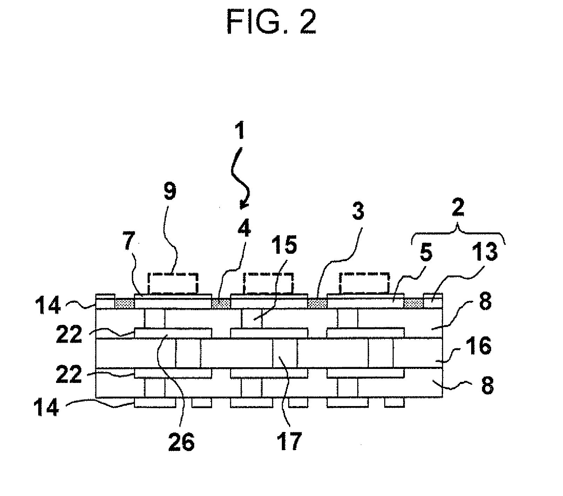

   Figure 2 is an A-A' cross sectional view of the wiring board according to Examples 1 to 10 of the present invention.
[Figure 3]

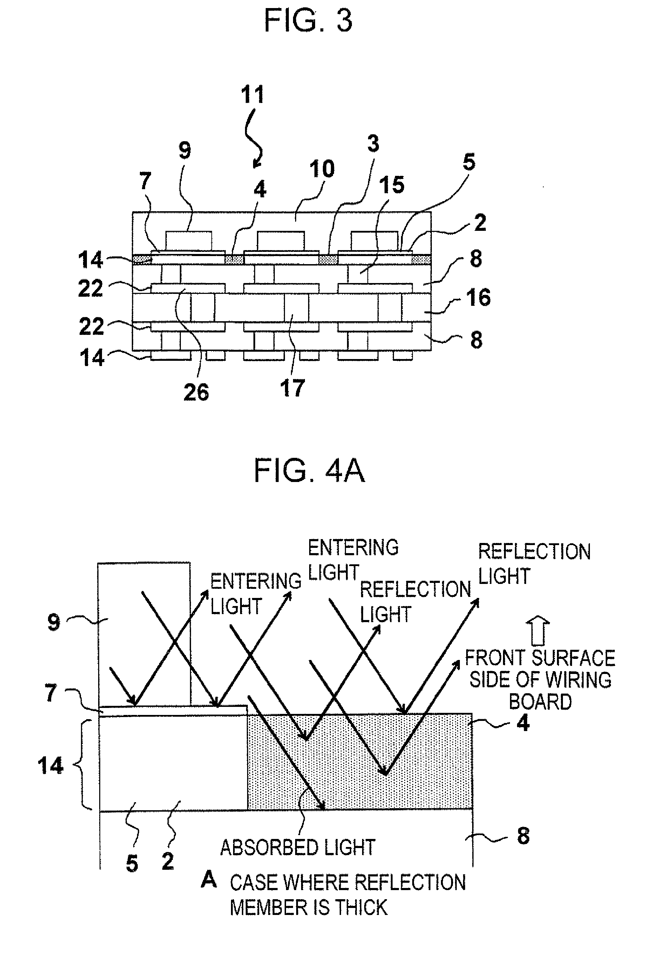

   Figure 3 is a cross sectional view of an electronic device package according to Examples 1 to 10 of the present invention.
[Figure 4A]
   Figure 4A is an enlarged view of the A-A' cross section of the wiring board according to Examples 1 to 10 of the present invention.
[Figure 4B]

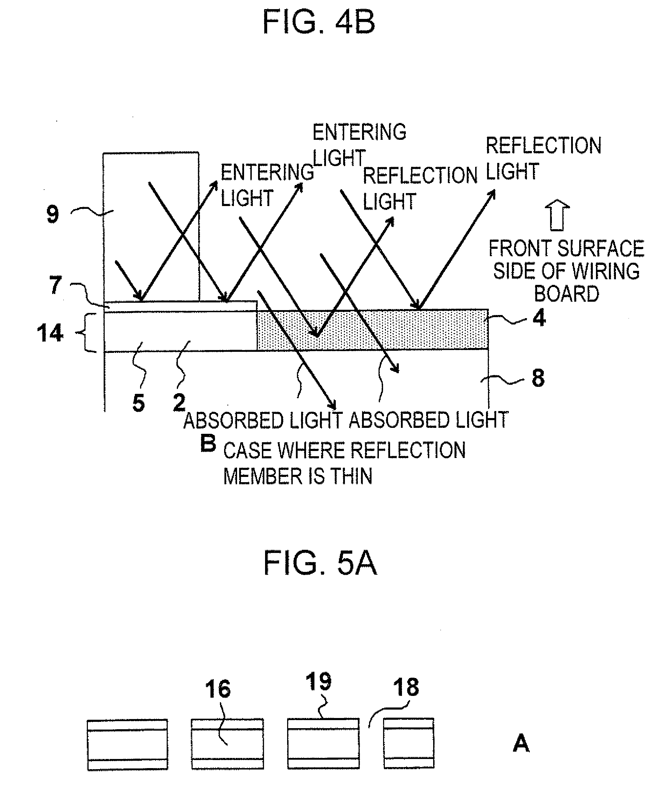

   Figure 4B is an enlarged view of the A-A' cross section of the wiring board according to Examples 1 to 10 of the present invention.
[Figure 5A]
   Figure 5A illustrates part of a production process of the wiring board and the electronic device package according to Examples 1 to 10 of the present invention.
[Figure 5B]

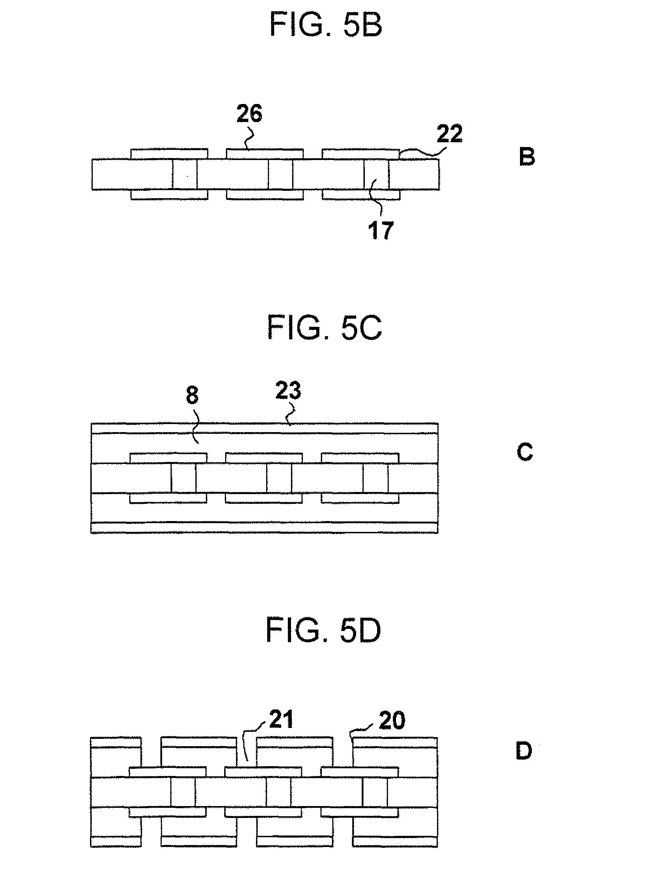

   Figure 5B illustrates part of the production process of the wiring board and the electronic device package according to Examples 1 to 10 of the present invention.
[Figure 5C]
   Figure 5C illustrates part of the production process of the wiring board and the electronic device package according to Examples 1 to 10 of the present invention.
[Figure 5D]
   Figure 5D illustrates part of the production process of the wiring board and the electronic device package according to Examples 1 to 10 of the present invention.
[Figure 5E]

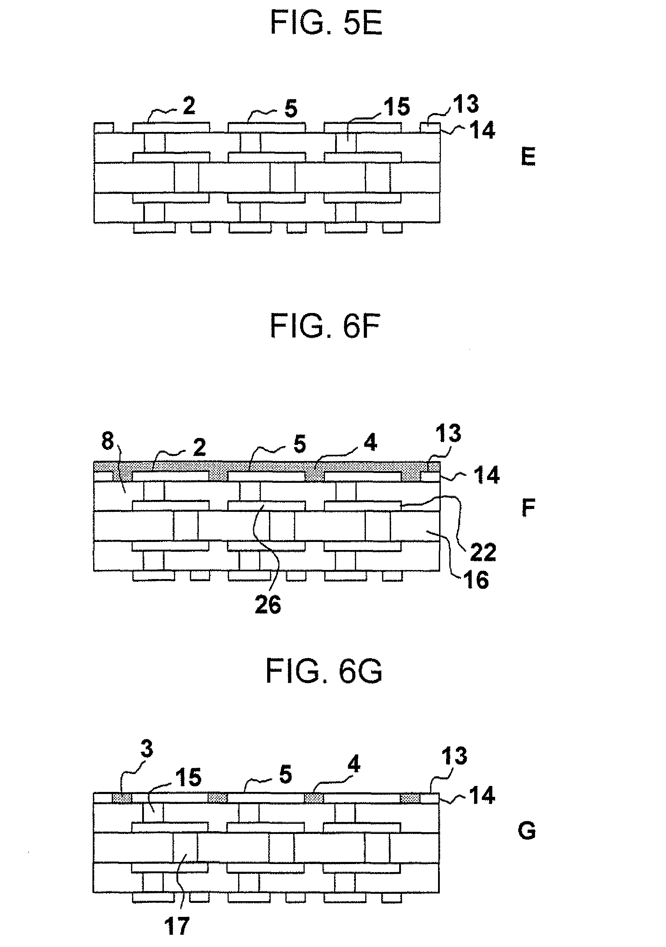

   Figure 5E illustrates part of the production process of the wiring board and the electronic device package according to Examples 1 to 10 of the present invention.
[Figure 6F]
   Figure 6F illustrates part of the production process of the wiring board and the electronic device package according to Examples 1 to 10 of the present invention.
[Figure 6G]
   Figure 6G illustrates part of the production process of the wiring board and the electronic device package according to Examples 1 to 10 of the present invention.
[Figure 6H]

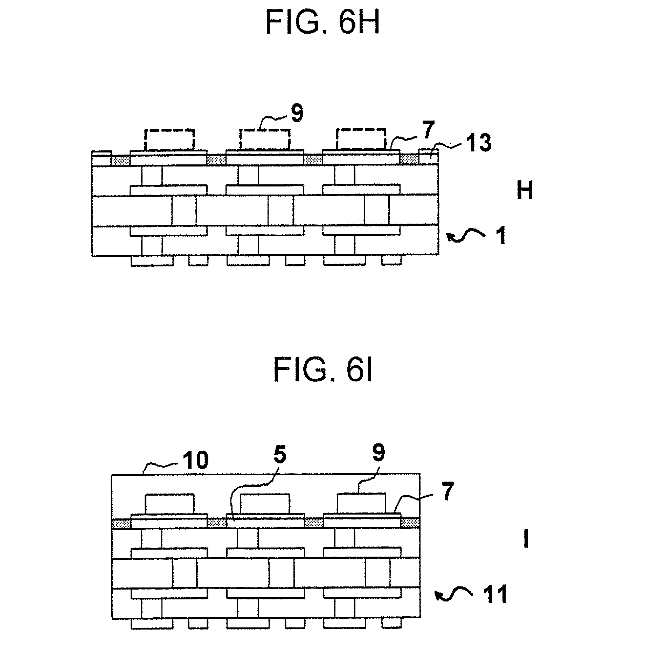

   Figure 6H illustrates part of the production process of the wiring board and the electronic device package according to Examples 1 to 10 of the present invention.
[Figure 6I]
   Figure 6I illustrates part of the production process of the wiring board and the electronic device package according to Examples 1 to 10 of the present invention.
[Figure 7]

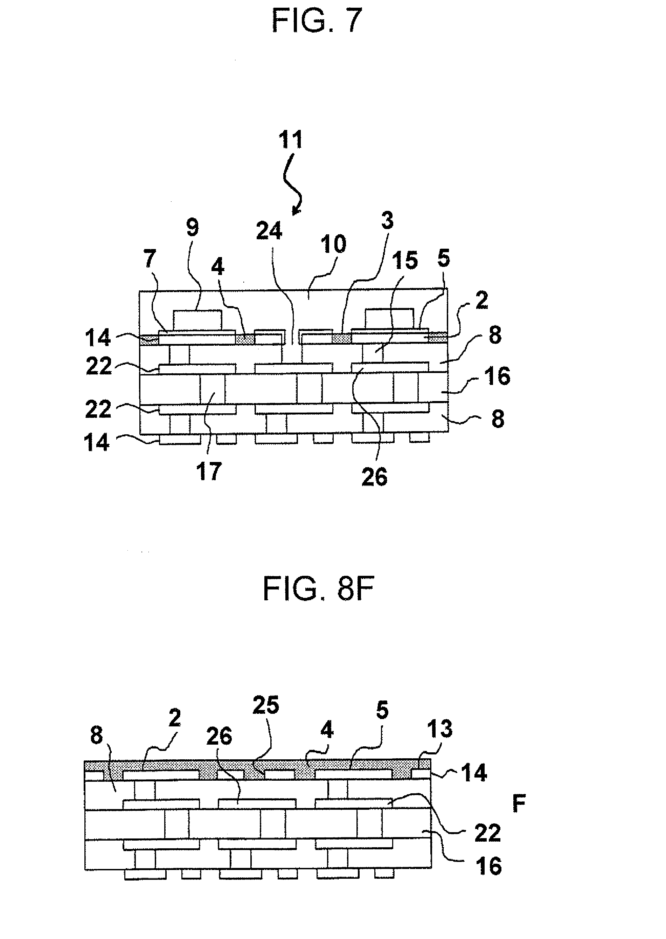

   Figure 7 is a cross sectional view of an electronic device package according to Example 11 of the present invention.
[Figure 8F]
   Figure 8F illustrates part of a production process of a wiring board and the electronic device package according to Example 11 of the present invention.
[Figure 8G]

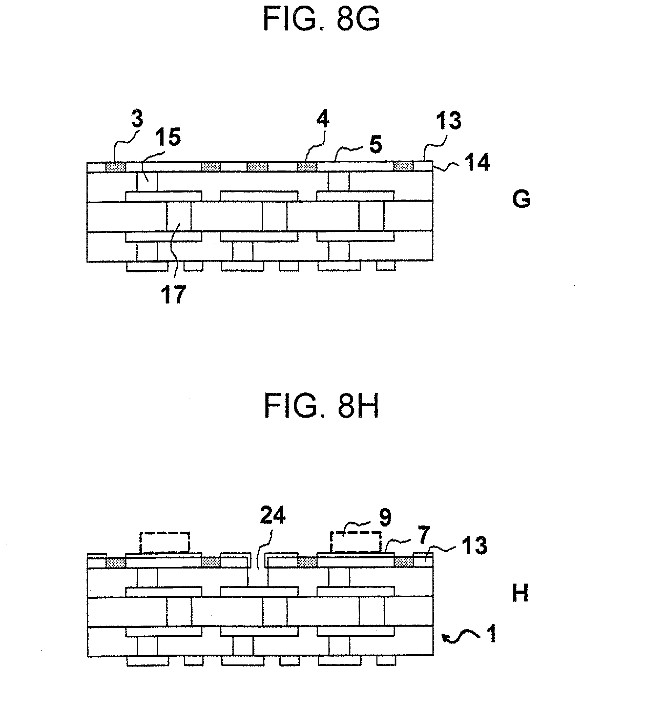

   Figure 8G illustrates part of the production process of the wiring board and the electronic device package according to Example 11 of the present invention.
[Figure 8H]
   Figure 8H illustrates part of the production process of the wiring board and the electronic device package according to Example 11 of the present invention.
[Figure 8I]

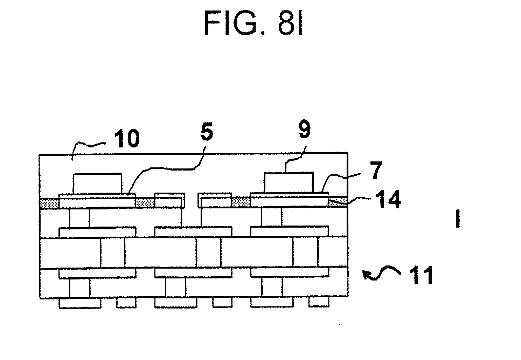

   Figure 8I illustrates part of the production process of the wiring board and the electronic device package according to Example 11 of the present invention.

### Description of Embodiments

A plan view of an example of a wiring board of the present invention is illustrated in Figure 1, and an A-A' cross sectional view is illustrated in Figure 2. For a wiring board 1 of the present invention, it is possible to exemplify such a wiring board as illustrated in these figures, including: a plurality of wiring layers 14 and 22 including conductor patterns 2 and 26 which are partially provided on base members 8 and 16; and the base members 8 and 16 which electrically insulate the plurality of wiring layers 14 and 22, in which: a reflection member 4 is formed on a portion of the base member 8 in which the conductor pattern 2 is not provided, in the outermost wiring layer 14 among the plurality of wiring layers 14 and 22; a surface of the reflection member 4 and a surface of the conductor pattern 2 are made level with each other; and the surface of the conductor pattern 2 is exposed from the reflection member 4.

The base member used in the present invention is an insulating member, and serves as a base body for providing thereon the wiring layer including the conductor pattern and the reflection member. A material constituting the base member is not particularly limited as long as the material can be used for the wiring board, and it is possible to use: a white base member (for example, a base member obtained by impregnating a reinforcement member such as glass cloth with a heat-curable resin containing titanium oxide and laminating the resultant member); and a general base member (for example, a base member obtained by impregnating a reinforcement member such as glass cloth and paper with an epoxy resin, a bismaleimide-triazine resin, and a phenolic resin and laminating the resultant member). It is not necessary to provide the base member itself with the reflection function, and hence costs of the base member can be reduced by using a general-purpose glass epoxy board, a general-purpose paper phenolic board, and the like among general base members.

In the present invention, the wiring layer 14 refers to a layer-like portion corresponding to a thickness of each of the conductor patterns 2 and 26 provided on the base members 8 and 16, when observed along the cross section as illustrated in Figure 2. When the reflection member 4 is formed at a gap between the conductor patterns 2, the wiring layer 14 refers to a layer-like portion including the reflection member 4. The plurality of wiring layers refer to the wiring layers 14 and 22 which are provided in a plurality of layers in the wiring board 1 having a multilayered structure, and also include, for example, a layer which is formed on a both-sided plate having interlayer connection. The outermost wiring layer 14 refers to a so-called outermost layer, and refers to a layer which is located outermost in the wiring board 1 and includes a conductor pattern used for mounting of the electronic device 9 and intermediation of electrical connection with the electronic device 9.

As illustrated in Figure 1 and Figure 2, a mounting electrode 5 for mounting the electronic device 9 thereon, a frame-like conductor 13 which surrounds the mounting electrode 5, and the like are formed on the conductor pattern 2 provided on the base member 8. The mounting electrode 5 is used to mount the electronic device 9 thereon, and corresponds to a so-called die pad. In addition, depending on the electronic device 9 to be mounted, an intermediary electrode 6 which serves as the intermediation of electrical connection with the electronic device 9 by wire bonding and the like is formed. The intermediary electrode 6 corresponds to a so-called bonding pad. The mounting electrode 5 may be formed independently or in pairs with the intermediary electrode 6 on the base member 8 as an electrode group in which a plurality of electrodes are arranged. The frame-like conductor 13 is formed so as to surround the mounting electrode 5, and in the case where the intermediary electrode 6 is formed, the frame-like conductor 13 may be formed so as to surround the mounting electrode 5 and the intermediary electrode 6. In the case where the mounting electrode 5 and the intermediary electrode 6 are formed as the electrode group in which the plurality of electrodes are arranged, the frame-like conductor 13 may be formed so as to surround the entire electrode group. In addition, the frame-like conductor 13 may be an independent conductor pattern 2 which is not electrically connected to the mounting electrode 5 and the intermediary electrode 6, or may double as a draw-out line from the mounting electrode 5 and the intermediary electrode 6, an electric supply line for electroplating, and the like. Because the frame-like conductor 13 surrounds the mounting electrode 5 and the intermediary electrode 6 in this way, even if the reflection member 4 is in the form of a liquid, the frame-like conductor 13 functions, at the time of application of, as a dam which holds back the reflection member 4 applied to a conductor pattern gap 3, and thus can suppress the reflection member 4 from flowing out to thereby vary a thickness thereof. Therefore, inside of the region of the frame-like conductor 13, even if the reflection member 4 is in the form of a liquid, the reflection member 4 is prevented from flowing out to thereby reduce the application thickness thereof, and hence the application thickness of the reflection member 4 can be secured by providing the frame-like conductor 13 so as to surround a region in which the reflection member 4 is to be provided. It should be noted that, in the case where the viscosity of the liquid reflection member 4 is high and thus is less likely to flow out, the frame-like conductor 13 does not need to completely surround the mounting electrode 5 and the intermediary electrode 6, and may be partially opened or may be formed into a broken line pattern.

The portion in which the conductor pattern is not provided refers to a portion at which the base member is exposed, for example, a conductor pattern gap. The conductor pattern gap refers to a gap formed between the conductor pattern and the conductor pattern, and refers to a gap for insulating adjacent conductor patterns. Therefore, a portion at which the base member is exposed inside of the frame-like conductor is always formed between the conductor patterns to insulate the conductor patterns from each other, and thus corresponds to the gap between the conductor patterns. The conductor pattern and the gap between the conductor patterns can be formed, for example, according to a method of removing by etching or the like a metal layer which is formed in advance on the base member and is made of copper foil or aluminum foil so as to leave only a portion which will become the conductor pattern, as performed in a general method of production of the wiring board.

The reflection member used in the present invention has a function of reflecting light while maintaining insulation at the conductor pattern gap. For such a reflection member, it is possible to exemplify a resin composition containing a light-curable resin or a heat-curable resin and a white pigment. An acrylic resin is exemplified as the light-curable resin, an epoxy resin is exemplified as the heat-curable resin, and the epoxy resin is desirable in terms of heat resistance and the like. It should be noted that a silicone resin is also exemplified as the heat-curable resin, but the silicone resin is generally low in adhesive force to another material, and hence the epoxy resin is desirable in consideration of close contact with the sealing member, the conductor pattern, and the like. If the reflection member is made of the epoxy resin, whether the sealing member used for molding is epoxy-based or silicone-based, close contact can be obtained, and hence the degree of freedom in selection is high.

For the epoxy resin used for the reflection member, it is possible to use a material containing an alicyclic epoxy resin (A), a white pigment (B), a curing agent (C), and a curing catalyst (D). For the white pigment (B), it is possible to use at least one selected from the group consisting of titanium oxide, silica, alumina, magnesium oxide, antimony oxide, aluminum hydroxide, barium sulfate, magnesium carbonate, and barium carbonate. In addition, it is desirable in terms of improvement in reflection rate that an average particle diameter of the white pigment (B) fall within a range of 0.1 µm to 50 µm and the white pigment (B) fall within a range of 10 vol% to 85 vol% of the entire resin composition. For the curing agent (C) and the curing catalyst (D), it is possible to use materials which are generally used for the epoxy resin.

As illustrated in Figure 2 and Figure 3, the reflection member 4 is provided in the outermost wiring layer 14. Because the reflection member 4 is provided in the outermost wiring layer 14, the reflection member 4 can efficiently reflect light from a light emitting element which is mounted as the electronic device 9 on the outermost wiring layer 14 and is used for the purpose of illumination, liquid crystal backlight, and the like. In addition, because the reflection member 4 is provided in the outermost wiring layer 14 on which the electronic device 9 is mounted, the base member 8 itself located below the reflection member 4 may have the reflection function, but does not necessarily need to have the reflection function. Therefore, a general-purpose base member which is used in a general wiring board can be used.

In addition, as illustrated in Figure 1 and Figure 2, the reflection member 4 is provided on the portion of the base member 8 in which the conductor pattern 2 is not provided, that is, at the conductor pattern gap 3 on the base member 8. As a result, the conductor pattern 2 of the wiring board 1 can obtain a high reflection rate by means of a reflection layer 7, and the conductor pattern gap 3 thereof can obtain a high reflection rate by means of the reflection member 4. Therefore, it is possible to improve the reflection rate of the surface including both of the conductor pattern 2 and the reflection member 4 of the wiring board 1.

For the reflection rate of the reflection member, in terms of the fact that the light emitted from the light emitting element used for the purpose of illumination, liquid crystal backlight, and the like can be efficiently reflected, it is desirable that the reflection member have a reflection rate of 70% or higher with respect to light having any wavelength between 420 ± 10 nm and 800 ± 10 nm. In particular, in the case where the reflection member has a reflection rate of 70% or higher with respect to light having a wavelength of 460 ± 10 nm, because an emitted light wavelength of a high-luminance light emitting element used for the purpose of general illumination is in the vicinity of 460 nm, it is desirable in terms of the fact that a high conversion efficiency can be obtained at the time of using such a high-luminance light emitting element. In addition, in the case where the reflection member has a reflection rate of 70% or higher with respect to light having a wavelength of 550 ± 10 nm, it is desirable in terms of the fact that a high conversion efficiency can be obtained with respect to green light emitted from the light emitting element. In the case where the reflection member has a reflection rate of 70% or higher with respect to light having a wavelength of 550 ± 10 nm, it is desirable in terms of the fact that a high conversion efficiency can be obtained with respect to green light emitted from the light emitting element. Further, in the case where the reflection member has a reflection rate of 700 or higher with respect to light within the entire wavelength range between 420 ± 10 nm and 800 ± 10 nm, it is desirable in terms of the fact that a high conversion efficiency can be obtained over an entire visible light range. Here, in the case where gold plating or silver plating is applied in order to impart a wire bonding property to the surface of the conductor pattern, the reflection rate of the gold- or silver-plated surface is 70% or higher with respect to the light within the entire wavelength range between 420 ± 10 nm and 800 ± 10 nm. Therefore, the reflection rate of the reflection member formed at the gap between the conductor patterns is set to 70% or higher with respect to light having any wavelength between 420 ± 10 nm and 800 ± 10 nm, whereby the reflection rate of the gap between the conductor patterns can be equivalent to or higher than the reflection rate of the conductor pattern to which gold plating or silver plating is applied. Accordingly, it is possible to achieve in a balanced manner both of the reflection rate and the wire bonding property on the conductor pattern, and obtain a high reflection rate over the entire surface of the wiring board. In addition, unevenness in reflection rate between the respective regions of the conductor pattern and the gap between the conductor patterns at which the reflection member is formed is small, so that unevenness in brightness can be reduced when the wiring board is used as a board for illumination and liquid crystal backlight.

As illustrated in Figure 2 and Figure 3, the surface of the reflection member 4 and the surface of the conductor pattern 2 are made level with each other, and the surface of the conductor pattern 2 is exposed from the reflection member 4. It should be noted that the state where the surface of the reflection member 4 and the surface of the conductor pattern 2 are made level with each other refers to that there is not any step at least in the vicinity of a boundary between the surface of the reflection member 4 and the surface of the conductor pattern 2, and includes the state where the surface of the reflection member 4 becomes gradually more concave than the surface of the conductor pattern 2 toward a region farther from the boundary. For example, in the case of using a method of collectively polishing the reflection member 4 and the conductor pattern 2 to thereby make the surfaces thereof level with each other, there is almost no step and the surfaces thereof become level with each other in the vicinity of the boundary between the surface of the reflection member 4 and the surface of the conductor pattern 2, but the surface of the reflection member 4 may become more concave than the surface of the conductor pattern 2 in a region far from the boundary, because the reflection member 4 is polished more easily than the conductor pattern 2. As described above, the surface of the reflection member 4 and the surface of the conductor pattern 2 are made level with each other, and the reflection member 4 and the conductor pattern 2 form a flat continuous surface. Therefore, there are not any loss and unevenness in reflection caused by a step at the boundary between the reflection member 4 and the conductor pattern 2, and hence the reflection rate of the entire surface of the wiring board 1 is improved. In addition, because there is not any step at the boundary between the reflection member 4 and the conductor pattern 2, when a sealing member 10 which is used when an electronic device package 11 is produced is formed on the wiring board 1, there is no fear that bubbles remain at the boundary between the reflection member 4 and the conductor pattern 2. The same holds true even for the case where the reflection layer 7 to be described later is provided on the conductor pattern 2. Therefore, the reliability of the electronic device package 11 can be improved. In addition, the surface of the conductor pattern 2 is exposed from the reflection member 4, and hence reflection on the surface of the conductor pattern 2 can be utilized. Therefore, if the reflection layer 7 having the reflection function is provided on the conductor pattern 2, the reflection rate of the entire wiring board 1 can be improved. In addition, because the height of the reflection member 4 is equivalent to that of the conductor pattern 2, the thickness of the reflection member 4 can be controlled with reference to the thickness of the conductor pattern 2, and hence the reflection member 4 can be formed at a uniform thickness over the entire wiring board 1. Therefore, it is possible to suppress variations in reflection rate due to variations in thickness of the reflection member 4, and the reflection function with small fluctuations in reflection rate can be realized over the entire wiring board 1. Further, the thickness of the conductor pattern 2 is changed as needed, whereby the thickness of the reflection member 4 can be arbitrarily set. Therefore, it is possible to deal with the case where a thickness required to obtain the reflection rate is different depending on a used material of the reflection member 4, and hence it is possible to reliably form the thickness of the reflection member 4 which is required to obtain the necessary reflection rate. In this way, when the surface of the conductor pattern 2 and the surface of the reflection member 4 are made level with each other and the surface of the conductor pattern 2 is exposed from the reflection member 4, the reflection rate of the surface of the wiring board 1 including the conductor pattern 2 and the reflection member 4 can be improved, fluctuations in reflection rate can be improved, and the reliability of the electronic device package 11 using the wiring board 1 can be improved.

Inside of the frame-like conductor, it is desirable that the reflection member be formed on the portion of the base member in which the conductor pattern is not provided so as to fill the gap between the conductor patterns. That is, the conductor pattern gap is covered by the reflection member without any space to the boundary with the conductor pattern, and the reflection member is brought into close contact with an end of the conductor pattern. As a result, the surface of the base member located below the conductor pattern gap is not exposed, and hence the reflection rate of the wiring board can be more improved. In addition, in the case where the reflection layer is formed by plating or the like on the conductor pattern after the reflection member is formed, it is possible to suppress a plating solution from entering or remaining at the boundary between the reflection member and the conductor pattern, so that the reliability is improved.

In order to make the surface of the conductor pattern and the surface of the reflection member level with each other and expose the surface of the conductor pattern on the reflection member, it is desirable to collectively polish the conductor pattern and the reflection member after the reflection member is formed on the portion of the base member in which the conductor pattern is not provided. Here, collectively polishing the conductor pattern and the reflection member refers to polishing the surface of the conductor pattern and the surface of the reflection member at the same time, to thereby form polished surfaces having the same height.
As a result, the heights of the surface of the conductor pattern and the surface of the reflection member become equivalent to each other, and hence the surface of the conductor pattern and the surface of the reflection member become level with each other. In addition, because both of the surface of the conductor pattern and the surface of the reflection member are polished, the surface of the conductor pattern is exposed from the reflection member.

The following method can be adopted as an example of the specific method for collectively polishing the conductor pattern and the reflection member to thereby make the surface of the reflection member and the surface of the conductor pattern level with each other and for exposing the surface of the conductor pattern on the reflection member. As illustrated in Figure 6F to Figure 6I, a liquid heat-curable resin, which is used as the material of the reflection member 4, is applied to the surface of the wiring board 1 to be cured thereon, and the reflection member 4 is formed on the wiring board 1 including at least the conductor pattern gap 3 so as to have a thickness larger than that of the conductor pattern 2 (step of Figure 6F). After that, the reflection member 4 and the conductor pattern 2 are polished from the surface of the reflection member 4 until the thickness of the reflection member 4 becomes equivalent to the thickness of the conductor pattern 2 and the surface of the conductor pattern 2 is exposed (step of Figure 6G). According to this method, the polishing can be finished at the time at which the conductor pattern 2 is exposed from the reflection member 4, and hence the end of the polishing is easily determined, and the workability is excellent. In addition, in general, the conductor pattern 2 is formed by etching copper foil or aluminum foil, and hence the conductor pattern 2 is formed so as to have a uniform thickness over the entire wiring board 1 in order to satisfy the accuracy in width of the conductor pattern 2. Therefore, the thickness of the reflection member 4 is made equivalent to the thickness of the conductor pattern 2, whereby the reflection member 4 itself is also formed at a uniform thickness over the entire wiring board 1.
It should be noted that, even if the polishing is further continued after the conductor pattern 2 is exposed from the reflection member 4, the surface of the conductor pattern 2 and the surface of the reflection member 4 are polished at the same time, and thus form the continuous polished surface, and hence the state where the surface of the reflection member 4 and the surface of the conductor pattern 2 are made level with each other and the surface of the conductor pattern 2 is exposed from the reflection member 4 is maintained. Therefore, controlling of the end of the polishing may be performed so that a predetermined thickness or larger of the reflection member 4 is secured, and thus does not need to be performed strictly, so that controlling of polishing conditions is easy.

The following method can be adopted as another example of the specific method for collectively polishing the conductor pattern and the reflection member to thereby make the surface of the reflection member and the surface of the conductor pattern level with each other and for exposing the surface of the conductor pattern on the reflection member. Although not illustrated, a liquid heat-curable resin, which is used as the material of the reflection member, is applied to the surface of the wiring board to be cured thereon, and the reflection member is formed on the wiring board including at least the gap between the conductor patterns so as to have a thickness smaller than that of the conductor pattern. After that, the conductor pattern is polished from the surface of the conductor pattern until the thickness of the conductor pattern becomes equivalent to the thickness of the reflection member and the surface of the conductor pattern becomes level with the surface of the reflection member. Similarly in this case, it is possible to make the surface of the reflection member and the surface of the conductor pattern level with each other and to expose the surface of the conductor pattern on the reflection member.

For the method of applying the material of the reflection member, it is possible to use a general method which is used for applying a liquid material to the wiring board. It is possible to adopt, for example, printing, spray coating, roll coating, and curtain coating, and the printing is desirable in terms of the fact that the material can be applied selectively to a necessary portion. In the case of adopting the printing, the process may be performed by using: a plate having a pattern which enables the material of the reflection member to be printed so that the surface of the conductor pattern is completely exposed; a plate which enables such printing that the material of the reflection member covers part of the surface of the conductor pattern; and a plate which enables such printing that the material of the reflection member completely covers the surface of the conductor pattern. In all cases, it is desirable that the thickness of the reflection member after application and curing be equivalent to or larger than that of the conductor pattern. As a result, the polishing may be performed from the surface of the reflection member, and may be finished at the time at which the conductor pattern is exposed from the reflection member or at the time at which the surface of the conductor pattern starts to be polished. Therefore, controlling of the end of the polishing is easy, and the thickness of the reflection member can be secured.

The curing performed after the liquid heat-curable resin, which is used as the reflection member, is applied to the wiring board may bring such a cured state that allows the subsequent polishing. For example, in the case of using an epoxy resin, a sufficient cured state can be obtained by heating under the conditions of approximately 130°C to 180°C and 30 minutes to 600 minutes.

For the polishing performed after the reflection member is applied and cured, it is possible to adopt, for example, mechanical polishing using a buffing machine, a belt sander, and the like. Particularly, mechanical polishing using a buff roll is preferable in terms of the fact that the entire wiring board can be polished with high accuracy. For the buff count, when #600, #800, #1000, and the like or the combination of these counts is used, an appropriate polishing speed is obtained, the end is easily determined, and a length of polishing time is short. Therefore, these counts or the combination thereof are desirable in terms of the workability and efficiency of polishing work. For the buff roll, it is possible to use, as the buff, nonwoven fabric, ceramic buff, diamond buff, and the like which are commercially available. It should be noted that, in the case where the reflection member and the conductor pattern are collectively subjected to buffing, there is almost no step and the surfaces thereof become level with each other in the vicinity of the boundary between the surface of the reflection member and the surface of the conductor pattern, but the surface of the reflection member tends to become more concave than the surface of the conductor pattern in a region far from the boundary, because the reflection member is polished more easily than the conductor pattern. The use of ceramic buff is desirable in terms of the fact that there is almost no concave and the surfaces thereof can be made level with each other not only in the vicinity of the boundary between the surface of the reflection member and the surface of the conductor pattern but also in the region far from the boundary, and accordingly the entire wiring board can be made flat. In addition, the polishing is performed with a polishing current being approximately 0.1 A to 2.0 A, and the current value is adjusted in accordance with thicknesses by which the reflection member and the conductor pattern are to be scraped off. Preferably, the current value is approximately 1.0 A to 1.4 A.

The surface roughness of the reflection member is not particularly limited, but it is desirable that the surface roughness thereof be 0.3 µm to 7 µm in Ra. Here, Ra is an arithmetic average roughness which is defined by JIS B 0601 (2001), and can be measured by using a stylus-type surface roughness measuring machine and the like. As a result, it is possible to obtain strong and close contact between the sealing member and the reflection member which are used when the electronic device package is produced, and hence the reliability is improved. In addition, it is possible to use, without any change, the polished surface obtained after performing the polishing for making the surface of the reflection member and the surface of the conductor pattern level with each other by using the buff roll or the like, and hence the workability and efficiency of polishing work can be maintained. In addition, it is not necessary to make the surface roughness of the reflection member as smooth as a mirror surface (here, corresponding to 0.1 µm or lower in Ra), and hence the time and effort for adjustment of the surface shape of the reflection member can be omitted. In addition, as an example in which the resin composition containing a heat-curable resin and a white pigment is used for the reflection member, as a result of experiments, it was found as shown in Table 1 that there is almost no decrease in the reflection rate after the mechanical polishing using the buff roll, compared with the reflection rate before the polishing (in Example 1 in which the buffing is performed, the reflection rate is 89% at 460 nm, and there is a decrease of approximately 3% compared with 92% in Comparative Example 2 in which the buffing is not performed), and hence it is possible to secure the reflection rate which is equivalent to that in a smooth state obtained after the liquid reflection member is applied and cured. Further, reflection light from the surface of the reflection member whose surface roughness is 1.6 µm or higher in Ra has a low degree of directivity, and is emitted in all directions on the surface of the wiring board, and hence there is an advantage that unevenness in brightness is less likely to occur in the case of use for liquid crystal backlight or illumination. It should be noted that, for the buff rolls used for the polishing in this case, #600, #800, #1000, and the like are combined in the stated order, to thereby enable the polishing.

The polishing which is performed so that the surface roughness of the reflection member becomes 0.3 µm to 1.5 µm in Ra imparts directivity to reflection light from the reflection member, and thus is advantageous in the case of use for illumination or the like which is required to have higher brightness at a specific portion. For the buff rolls used for the polishing in this case, #600, #800, #1000, #2000, and the like may be combined in the stated order, to thereby enable the polishing. If Ra becomes smaller than 0.3 µm, a buff roll with a still smaller count needs to be used. In this case, man-hours are required for adjustment of the surface roughness, whereas the reflection rate is hardly improved, which is therefore not preferable in terms of cost-effectiveness. On the other hand, if Ra becomes larger than 7 µm, the surface roughness of the conductor pattern becomes larger together, and hence the surface roughness of the reflection layer formed on the conductor pattern also becomes larger. As a result, there is a possibility that the reflection rate of the reflection layer decreases and a possibility that heat radiation from the electronic device decreases because a contact area with the electronic device mounted thereon becomes smaller.

It is desirable that the thickness of the reflection member on the base member be 10 µm to 50 µm. As a result, as illustrated in Figure 4A, most (70% or higher between 420 ± 10 nm and 800 ± 10 nm) of the light which enters the surface of the reflection member 4 from the electronic device 9 mounted on the surface of the wiring board is reflected without reaching the surface of the base member 8 having a lower reflection rate than that of the reflection member 4, and hence the reflection rate can be improved. In the case where the thickness of the reflection member 4 is smaller than 10 µm, as illustrated in Figure 4B, a larger part of the light which enters the surface of the reflection member 4 from the electronic device reaches the surface of the base member 8 having a lower reflection rate than that of the reflection member 4 to be absorbed thereby, and hence the reflection rate tends to decrease. In the case where the thickness of the reflection member 4 is larger than 50 µm, the thickness of the conductor pattern 2 also becomes larger together in order to form the reflection member to this thickness, and hence there is a tendency that a fine pattern becomes difficult to deal with. In addition, even if the reflection member 4 is formed so as to have a thickness of 50 µm or larger, the reflection rate is not improved, which is therefore not preferable in terms of an increase in material costs of the reflection member 4. It should be noted that, when the thickness of the reflection member 4 on the base member 8 is 15 µm to 50 µm, it is more desirable in terms of the fact that the reflection rate is improved (80% or higher between 420 ± 10 nm and 800 ± 10 nm), and when the thickness thereof is 18 µm to 50 µm, it is much more desirable in terms of the fact that the reflection rate is further improved (90% or higher between 420 ± 10 nm and 800 ± 10 nm).

As illustrated in Figure 2 and Figure 3, it is desirable that the reflection layer 7 for reflecting light with high efficiency be formed on the conductor pattern 2. In the case where the electronic device 9 to be mounted thereon is a light emitting element used for the purpose of illumination, liquid crystal backlight, and the like, in terms of the fact that light emitted from the electronic device 9 can be efficiently reflected, it is desirable that the reflection layer 7 have a reflection rate of 70% or higher with respect to light having any wavelength between 420 ± 10 nm and 800 ± 10 nm. In particular, in the case where the reflection layer 7 has a reflection rate of 70% or higher with respect to light having a wavelength of 460 ± 10 nm, because an emitted light wavelength of a high-luminance light emitting element used for the purpose of general illumination is in the vicinity of 460 nm, it is desirable in terms of the fact that a high conversion efficiency can be obtained at the time of using such a high-luminance light emitting element. In addition, in the case where the reflection layer 7 has a reflection rate of 70% or higher with respect to light having a wavelength of 550 ± 10 nm, it is desirable in terms of the fact that a high conversion efficiency can be obtained with respect to green light emitted from the light emitting element. In the case where the reflection layer 7 has a reflection rate of 70% or higher with respect to light having a wavelength of 550 ± 10 nm, it is desirable in terms of the fact that a high conversion efficiency can be obtained with respect to green light emitted from the light emitting element. Further, in the case where the reflection layer 7 has a reflection rate of 70% or higher with respect to light within the entire wavelength range between 420 ± 10 nm and 800 ± 10 nm, it is desirable in terms of the fact that a high conversion efficiency can be obtained over an entire visible light range. For the reflection layer 7, it is possible to use a gold or silver-white metal layer which is formed by plating, vapor deposition, and the like. Gold is exemplarily used for the gold metal layer, and silver, aluminum, zinc, nickel, and the like are exemplarily used for the silver-white metal layer. It should be noted that even the thickness of the reflection layer 7 which is equal to or larger than 1 µm and equal to or smaller than 5 µm (including the case where base plating is applied) is sufficient to impart the reflection function to the conductor pattern 2. In order to level the surface of the conductor pattern after the polishing to thereby reduce the surface roughness, it is desirable to make the thickness equal to or larger than 3 µm. Therefore, when the reflection layer 7 is formed on the conductor pattern 2, the reflection layer 7 may become higher by up to approximately 5 µm (including the base plating) than the reflection member 4, but a step with this height does not affect the reflection rate normally, and there is no fear that bubbles are contained therein when the sealing member 10 is formed.

It should be noted that, even if the step between the reflection layer and the reflection member is equal to or smaller than approximately 5 µm, in the case where a problem that bubbles are contained in the sealing member arises, this problem can be solved in the following manner. That is, the conductor pattern and the reflection member are collectively polished, whereby the surface of the reflection member and the surface of the conductor pattern become level with each other and the surface of the conductor pattern is exposed from the reflection member. After that, before the reflection layer is formed on the conductor pattern, the conductor pattern is concaved in advance by etching or the like by a thickness corresponding to the reflection layer with respect to the surface of the reflection member. According to this method, the step between the reflection layer and the reflection member can be eliminated, and moreover, it is also possible to obtain an effect of smoothing, by etching or the like, the surface of the conductor pattern which has become rough as a result of the polishing. Therefore, because the surface of the conductor pattern becomes smooth, the surface of the reflection layer to be formed on this smoothed surface also becomes smoother, and hence the reflection rate of the surface of the reflection layer can be improved. In addition, in the case where this conductor pattern is the mounting electrode for the electronic device, a contact area with the electronic device increases, so that heat radiation from the electronic device can be improved.

For the conductor pattern, in the case where a high reflection rate of 90% or higher with respect to light having any wavelength between 420 ± 10 nm and 800 ± 10 nm is required, a silver-white metal layer formed by silver plating is preferable for the reflection layer in terms of the fact that light having a short wavelength used for illumination and liquid crystal backlight is more efficiently reflected. As a result, light emitted to the conductor pattern can be efficiently reflected, and hence high luminance can be secured in the case where the light emitting element is mounted as the electronic device.
The reflection rate of silver tends to decrease due to surface oxidation after a long period of use, and hence silver may be unsuitable for usage in which a stable reflection rate is required over a long period, but has the advantage of being suitable for usage in which the high luminance is prioritized over the lifetime.

In the case where the stability in reflection rate over a long period is prioritized over the high luminance, it is desirable that the reflection layer be formed by gold plating. The surface of gold is not oxidized even after a long period of use, and hence a decrease in reflection rate is suppressed. In addition, when the intermediary electrode and the electronic device are electrically connected to each other by wire bonding using a gold wire as a bonding wire, the wire bonding property can be secured.

For the conductor pattern, in the case where a high reflection rate with respect to light having any wavelength between 420 ± 10 nm and 800 ± 10 nm is required and the intermediary electrode is required to have a wire bonding property to a gold wire, it is desirable that the reflection layer be provided by silver plating on the mounting electrode, and the reflection layer be provided by gold plating on the intermediary electrode. Because gold plating which has an excellent joining property to the gold wire is applied to the intermediary electrode, the wire bonding property is secured. Further, because silver plating having a high reflection rate of 90% or higher with respect to light within a wavelength range between 420 ± 10 nm and 800 ± 10 nm, which is an emitted light wavelength from the electronic device, is applied to the mounting electrode, a high reflection rate can be secured. In addition, as illustrated in Figure 4A and Figure 4B, the mounting electrode 5 also reflects light emitted from a bottom part of the electronic device 9 (that is, a surface thereof joined to the mounting electrode 5), and this reflection light passes through the electronic device 9 itself to be emitted toward the surface of the wiring board 1. Therefore, it is possible to utilize the light emitted from the bottom part of the electronic device 9 (that is, the surface thereof joined to the mounting electrode 5), so that the light conversion efficiency can be improved.

It is desirable that both of the conductor pattern and the reflection member have a reflection rate of 70% or higher with respect to light having any wavelength between 420 ± 10 nm and 800 ± 10 nm. This enables the entire wiring board to have a reflection rate of 70% or higher with respect to light having any wavelength between 420 ± 10 nm and 800 ± 10 nm, and hence it becomes possible to efficiently utilize light from the light emitting element. In particular, in the case where both of the conductor pattern and the reflection member have a reflection rate of 70% or higher with respect to light having a wavelength of 460 ± 10 nm, it becomes possible to provide, particularly, a wiring board which is suitable for use for the purpose of general illumination and liquid crystal backlight. In addition, because not only the conductor pattern but also the gap between the conductor patterns at which the reflection member is formed has the reflection function, unevenness in reflection rate is less likely occur and fluctuations in luminance are suppressed over the entire wiring board.

For mounting the electronic device on the mounting electrode, any of wire-bond mounting and flip-chip mounting may be adopted as a method of mounting an LSI chip 1. In the case where electrical conduction between the mounting electrode and the electronic device is required, the electronic device can be mounted on the mounting electrode by means of a silver paste, a conductive adhesive, soldering, and the like. In the case where electrical conduction between the mounting electrode and the electronic device is not required, the electronic device can be adhered and mounted by means of an insulative adhesive and the like. In the case of the wire-bond mounting, the electronic device and the intermediary electrode are joined to each other by wire bonding.

The electronic device and the mounting electrode are sealed by using a sealing member used for a general electronic device package to thereby perform potting or transfer molding. For the sealing member, it is possible to use an epoxy resin, a polyimide resin, a silicone resin, a urethane phenolic resin, a polyester resin, an acrylic resin, other heat-curable resins, other thermoplastic resins, and the like.

In order to cut the wiring board after the sealing member is formed therein into electronic device packages as individual pieces, it is possible to use a method of cutting into individual pieces by cutting work called router or dicing.

It is desirable that a concave part 24 opened upward be provided in the reflection member 4 of the outermost wiring layer 14 as illustrated in Figure 7. The concave part 24 is opened upward in order to allow the sealing member 10 formed on the wiring layer 14 to easily flow into the concave part 24, and is formed as a non-through hole in order to prevent the sealing member 10 from flowing out toward the lower part of the wiring board 1. As a result, when the electronic device 9 is mounted on the mounting electrode 5 of the conductor pattern 2 and then the conductor pattern 2 and the electronic device 9 are sealed and molded by using the sealing member 10, the sealing member 10 flows into the concave part 24 provided in the reflection member 4, and is cured while filling the inside of the concave part 24. Therefore, an anchor effect can be obtained, and accordingly close contact between the reflection member 4 and the sealing member 10 is more ensured, with the result that the reliability is improved.

For the method of providing the concave part opened upward in the reflection member of the outermost wiring layer, it is possible to exemplify a method in which a laser beam machine, a drill machine, or the like is used, and a machining depth from the surface of the reflection member is controlled, to thereby form the concave part. Particularly, in the case of using the laser beam machine, as illustrated in Figure 8F to Figure 8I, a window hole 25 is formed in the wiring layer 14 on the base member 8 at a position at which the concave part 24 opened upward is to be provided, and the conductor pattern 26 which is to be subjected to laser irradiation is provided in the inner wiring layer 22 on the base member 16 for the inner layer, whereby a so-called conformal technique facilitates the formation of the concave part 24 which passes through the reflection member 4 and the base member 8 to reach the conductor pattern 26. It should be noted that, in the case of using the laser beam machine, the concave part 24 which reaches the conductor pattern 26 may be formed from the surface of the reflection member 4 without providing the conductor pattern 2 which is to serve as the window hole 25. In addition, the concave part 24 may be formed by controlling the machining depth from the surface of the reflection member 4 without providing any of the conductor pattern 2 which is to serve as the window hole 25 and the conductor pattern 26 which is to be subjected to laser irradiation.

### Examples

Hereinafter, examples of the present invention are described, and the present invention is not limited thereto.

### (Example 1)

As illustrated in a step of Figure 5A, MCL-E679F (product name, produced by Hitachi Chemical Company, Ltd.) which is an epoxy resin glass cloth copper clad laminate having a thickness of 0.06 mm, in which a copper foil 19 having a thickness of 12 µm was attached to both surfaces of the base member 16 for the inner layer, was prepared, and a through hole 18 for interlayer connection was formed by using MARK-100 (product name, produced by Hitachi Seiko Engineering, Ltd.) which is an NC drill machine.

Next, a cleaning process for the through hole 18 was performed by using a sodium permanganate solution under the conditions of a temperature of 85°C and 6 minutes. Then, base copper plating of 0.5 µm was applied to the entire surface of the base member 16 for the inner layer including the inside of the through hole by using CUST201 (product name, produced by Hitachi Chemical Company, Ltd.) which is electroless copper plating, 10 g/l of copper sulfate, 40 g/l of EDTA (ethylenediaminetetraacetic acid), 10 ml/l of formalin, and pH 12.2 under the conditions of a temperature of 24°C and a length of time of 30 minutes. Next, electrolytic copper plating having a plating thickness of 20 µm was formed on the entire surface of the base member 16 for the inner layer including the inside of the through hole by using copper sulfate plating under the conditions of a temperature of 30°C, a current density of 1.5 A/dm2, and a length of time of 60 minutes.

Next, as illustrated in a step of Figure 5B, an ultraviolet-curable etching resist dry film H-W425 (product name, produced by Hitachi Chemical Company, Ltd.) was temporarily pressure-bonded to the surface of the copper foil 19 for forming the wiring layer 22 on the base member 16 for the inner layer by using a laminating machine under the conditions of a pressure of 0.2 MPa, a temperature of 110°C, and a rate of 1.5 m/min. Subsequently, a negative mask was attached to an upper surface of the resultant structure. The surface was exposed to ultraviolet rays. The conductor pattern was printed onto the surface, and was developed by using a 1 mass sodium carbonate solution. An etching resist was formed thereon. A portion of the copper foil in which the etching resist was not formed was etched by spray atomization of a copper (II) chloride etching solution containing copper (II) chloride, hydrochloric acid, and a sulfuric acid-hydrogen peroxide mixture under the conditions of a pressure of 0.2 MPa and a rate of 3.5 m/min. Further, a 3 mass% sodium hydroxide solution was sprayed, to thereby separate and remove the etching resist. In this manner, the inner wiring layer 22 was formed on each of the front and rear surfaces of the base member 16 for the inner layer.

Next, as illustrated in a step of Figure 5C, GEA-679NUJY (product name, produced by Hitachi Chemical Company, Ltd.) which is an epoxy resin glass cloth prepreg having a thickness of 0.06 mm was prepared as the base member 8. In addition, 3EC-VLP-5 (product name, Mitsui Mining & Smelting Co., Ltd) which is copper foil having a thickness of 5 µm was prepared as a copper foil 23 for forming the wiring layer 14. The epoxy resin glass cloth prepreg was placed on top of the previously prepared inner wiring layer 22 on both the surfaces of the base member 16 for the inner layer, and the copper foil 23 for forming the wiring layer 14 having a thickness of 5 µm was further placed on top thereof. Then, the layers were heated under pressure to be integrally laminated by using a vacuum press machine under the conditions of a pressure of 3 MPa, a temperature of 175°C, and a length of holding time of 1.5 hours. In this way, the base member 8 and the copper foil 23 for forming the wiring layer 14 were integrally laminated on both the surfaces of the base member 16 for the inner layer.

Next, as illustrated in a step of Figure 5D, an ultraviolet-curable etching resist dry film H-W425 (product name, produced by Hitachi Chemical Company, Ltd.) was temporarily pressure-bonded to the surface of the copper foil 23 for forming the wiring layer 14 by using a laminating machine under the conditions of a pressure of 0.2 MPa, a temperature of 110°C, and a rate of 1.5 m/min. Subsequently, a negative mask was attached to an upper surface of the resultant structure. The surface was exposed to ultraviolet rays. A pattern of the window hole was printed onto the surface, and was developed by using a 1 mass% sodium carbonate solution. An etching resist was formed thereon. A copper portion in which the etching resist was not formed was etched by spray atomization of a copper (II) chloride etching solution containing copper (II) chloride, hydrochloric acid, and a sulfuric acid-hydrogen peroxide mixture under the conditions of a pressure of 0.2 MPa and a rate of 3.5 m/min. Further, a 3 mass% sodium hydroxide solution was sprayed, to thereby separate and remove the etching resist. In this manner, the window hole 20 for the conformal technique was formed.

Next, a laser hole 21 was formed in the base member 8 by using an NC laser beam machine MARK-20 (product name, produced by Hitachi Seiko Engineering, Ltd.) under the conditions of an aperture diameter of 0.26, an output of 500 W, a pulse width of 15, and a shot count of 15. Subsequently, a cleaning process for the laser hole 21 was performed by using a sodium permanganate solution under the conditions of a temperature of 85°C and 6 minutes. Then, base copper plating having a thickness of 0.5 µm was applied to the entire surface of the base member 8 including the inside of the laser hole 21 by using CUST201 (product name, produced by Hitachi Chemical Company, Ltd.) which is electroless copper plating, 10 g/l of copper sulfate, 40 g/l of EDTA (ethylenediaminetetraacetic acid), 10 ml/l of formalin, and pH 12.2 under the conditions of a temperature of 24°C and a length of time of 30 minutes.

Next, plating was performed for a predetermined length of time by using copper sulfate plating under the conditions of a temperature of 30°C and a current density of 1.5 A/dm², to thereby form electrolytic copper plating having a thickness of 20 µm on the entire surface of the base member 8 including the inside of the laser hole 21.

Next, as illustrated in a step of Figure 5E, an ultraviolet-curable etching resist dry film H-W475 (product name, produced by Hitachi Chemical Company, Ltd.) was temporarily pressure-bonded to the surface of the electrolytic copper plating on the base member 8 by using a laminating machine under the conditions of a pressure of 0.2 MPa, a temperature of 110°C, and a rate of 1.5 m/min. Subsequently, a negative mask was attached to an upper surface of the resultant structure. The surface was exposed to ultraviolet rays. The conductor pattern was printed onto the surface, and was developed by using a 1 mass% sodium carbonate solution. An etching resist was formed thereon. A copper portion in which the etching resist was not formed was etched by spray atomization of a copper (II) chloride etching solution containing copper (II) chloride, hydrochloric acid, and a sulfuric acid-hydrogen peroxide mixture under the conditions of a pressure of 0.2 MPa and a rate of 3.5 m/min, so that the outermost wiring layer 14 was formed. Subsequently, a 3 mass% sodium hydroxide solution was sprayed, to thereby separate and remove the etching resist. As a result, the conductor pattern 2 including the mounting electrode 5, the intermediary electrode (not shown), and the frame-like conductor 13 was formed as the outermost wiring layer 14 on the surface of the base member 8. The thickness of the formed conductor pattern 2 was about 23 µm on the average between the four corners and the center of the wiring board 1.

Next, as illustrated in a step of Figure 6F, the liquid reflection member 4 was applied by printing to the entire surface of the base member 8 including the conductor pattern 2. A reflection member A was used as the liquid reflection member 4. The reflection member A was made by mixing: 100 parts by mass of triglycidyl isocyanurate (product name: TEPIC-S, produced by Nissan Chemical Industries, Ltd.) as the heat-curable resin (epoxy resin); 150 parts by mass of methylhexahydrophthalic anhydride (product name: HN-5500F, produced by Hitachi Chemical Company, Ltd.) as the curing agent (acid anhydride curing agent); 470 parts by mass of titanium oxide (product name: FTR-700, produced by Sakai Chemical Industry Co., Ltd., average particle diameter: 0.2 µm) as the white pigment; and 1.5 parts by mass of tetra-n-butylphosphonium-o,o-diethylphosphorodithioate (product name: PX-4ET, produced by Nippon Chemical Industrial Co., Ltd.) as the curing catalyst (curing accelerator), and roll-kneading the mixture under the conditions of a kneading temperature of 20 to 30°C and a length of kneading time of 10 minutes. The viscosity of the obtained white liquid reflection member 4 was 10 Pa·s at 25°C.

Next, the reflection member 4 was formed on the entire surface of the base member 8 including the conductor pattern 2 by heating and curing for 2 hours at 150°C in a hot air circulation furnace. After that, as illustrated in a step of Figure 6G, the surface of the reflection member 4 was polished until the surface of the reflection member 4 became substantially level with the surface of the conductor pattern 2 and the entire surface of the conductor pattern 2 was completely exposed from the reflection member 4. In this polishing, mechanical polishing using buff rolls (produced by Ishii Hyoki Co., Ltd.) was performed. For the counts of the used buff rolls, #600, #800, and #1000 were used in combination in the stated order. For the buff rolls, JP Buff Monster V3/V3-D2 (product name, Jaburo Industry Co., Ltd.) for polishing a plugging resin was used. In addition, the polishing current was 1.2 A. The thicknesses of the conductor pattern 2 and the reflection member 4 in the vicinity thereof after the polishing were both about 18 µm on the average between the four corners and the center of the wiring board 1.

Next, as illustrated in a step of Figure 6H, electroless nickel-gold plating and electrolytic silver plating were applied to the entire conductor pattern 2, whereby the reflection layer 7 having a thickness of 3 µm was formed. In such a manner as described above, the wiring board 1 was produced.

Next, as illustrated in a step of Figure 6I, the light emitting element was mounted as the electronic device 9 on the mounting electrode 5 by die bonding, and the electronic device 9 and the intermediary electrode (not shown) were electrically connected to each other by wire bonding (not shown). Next, sealing was performed by using an epoxy resin as the sealing member 10, and a portion of the frame-like conductor 13 was cut and removed, whereby the electronic device package 11 was produced.

### (Example 2)

In the step of Figure 5D and the step of Figure 5E, electrolytic copper plating having a thickness of 15 µm was formed on the entire surface of the base member 8 including the inside of the laser hole, and the thickness of the conductor pattern 2 formed on the surface of the base member 8 was about 19 µm on the average between the four corners and the center of the wiring board 1. In addition, in the step of Figure 6G, the thicknesses of the conductor pattern 2 and the reflection member 4 in the vicinity thereof after the polishing were both about 14 µm on the average between the four corners and the center of the wiring board 1. Except for this, the wiring board 1 was produced in the same manner as in Example 1.

### (Example 3)

In the step of Figure 5D and the step of Figure 5E, electrolytic copper plating having a thickness of 30 µm was formed on the entire surface of the base member 8 including the inside of the laser hole, and the thickness of the conductor pattern 2 formed on the surface of the base member 8 was about 33 µm on the average between the four corners and the center of the wiring board 1. In addition, in the step of Figure 6G, the thicknesses of the conductor pattern 2 and the reflection member 4 in the vicinity thereof after the polishing were both about 28 µm on the average between the four corners and the center of the wiring board 1. Except for this, the wiring board 1 was produced in the same manner as in Example 1.

### (Example 4)

In the step of Figure 5D and the step of Figure 5E, electrolytic copper plating having a thickness of 50 µm was formed on the entire surface of the base member 8 including the inside of the laser hole, and the thickness of the conductor pattern 2 formed on the surface of the base member 8 was about 53 µm on the average between the four corners and the center of the wiring board 1. In addition, in the step of Figure 6G, the thicknesses of the conductor pattern 2 and the reflection member 4 in the vicinity thereof after the polishing were both about 47 µm on the average between the four corners and the center of the wiring board 1. Except for this, the wiring board 1 was produced in the same manner as in Example 1.

### (Example 5)

In the step of Figure 6G, at the time of performing the mechanical polishing using buff rolls on the surface of the reflection member 4, #600, #800, #1000, and #2000 were used as the buff rolls in the stated order. The thicknesses of the conductor pattern 2 and the reflection member 4 in the vicinity thereof after the polishing were both about 18 µm on the average between the four corners and the center of the wiring board 1. Except for this, the wiring board 1 was produced in the same manner as in Example 1.

### (Example 6)

In the step of Figure 6G, at the time of performing the mechanical polishing using buff rolls on the surface of the reflection member 4, #600 and #800 were used as the buff rolls in the stated order. The thicknesses of the conductor pattern 2 and the reflection member 4 in the vicinity thereof after the polishing were both about 20 µm on the average between the four corners and the center of the wiring board 1. Except for this, the wiring board 1 was produced in the same manner as in Example 1.

### (Example 7)

As illustrated in the step of Figure 6H, electroless nickel-gold plating and electrolytic gold plating were applied to the entire conductor pattern, whereby the reflection layer 7 was formed. The thicknesses of the conductor pattern 2 and the reflection member 4 in the vicinity thereof after the polishing were both about 20 µm on the average between the four corners and the center of the wiring board 1. Except for this, the wiring board was produced in the same manner as in Example 1.

### (Example 8)

In the step of Figure 6F, a reflection member B was used as the liquid reflection member 4 which was applied by printing to the entire surface of the base member 8 including the conductor pattern 2. The reflection member B was made by mixing: 100 parts by mass of CELLOXIDE 2021P (product name, produced by Daicel Chemical Industries, Ltd.) which is an alicyclic epoxy resin, as the heat-curable resin (epoxy resin); 120 parts by mass of methylhexahydrophthalic anhydride (product name: HN-5500F, produced by Hitachi Chemical Company, Ltd.); 410 parts by mass of titanium oxide (product name: FTR-700, produced by Sakai Chemical Industry Co., Lid.); and 1.5 parts by mass of tetra-n-butylphosphonium-o,o-diethylphosphorodithioate (product name: PX-4ET, produced by Nippon Chemical Industrial Co., Ltd.), and roll-kneading the mixture under the conditions of a kneading temperature of 20 to 30°C and a length of kneading time of 10 minutes. The viscosity of the obtained white liquid reflection member 4 was 8 Pa·s at 25°C. In addition, in the step of Figure 6G, the thicknesses of the conductor pattern 2 and the reflection member 4 in the vicinity thereof after the polishing were both about 18 µm on the average between the four corners and the center of the wiring board 1. Except for this, the wiring board 1 was produced in the same manner as in Example 1.

### (Example 9)

In the step of Figure 6F, a reflection member C was used as the liquid reflection member 4 which was applied by printing to the entire surface of the base member 8 including the conductor pattern 2. The reflection member C was made as the white liquid reflection member 4 by mixing: 50 parts by mass of triglycidyl isocyanurate (product name: TEPIC-S, produced by Nissan Chemical Industries, Ltd.); 50 parts by mass of CELLOXIDE 2021P (product name, produced by Daicel Chemical Industries, Ltd.); 135 parts by mass of methylhexahydrophthalic anhydride (product name: HN-5500F, produced by Hitachi Chemical Company, Ltd.); 440 parts by mass of titanium oxide (product name: FTR-700, produced by Sakai Chemical Industry Co., Ltd.); and 1.5 parts by mass of tetra-n-butylphosphonium-o,o-diethylphosphorodithioate (product name: PX-4ET, produced by Nippon Chemical Industrial Co., Ltd.), and roll-kneading the mixture under the conditions of a kneading temperature of 20 to 30°C and a length of kneading time of 10 minutes. The viscosity of the obtained white liquid reflection member 4 was 12 Pa·s at 25°C. In addition, in the step of Figure 6G, the thicknesses of the conductor pattern 2 and the reflection member 4 in the vicinity thereof after the polishing were both about 21 µm on the average between the four corners and the center of the wiring board 1. Except for this, the wiring board 1 was produced in the same manner as in Example 1.

### (Comparative Example 1)

In the step of Figure 6F, the reflection member 4 was not applied to the conductor pattern 2 and the base member 8, and the base member 8 was left exposed. The thickness of the conductor pattern 2 was about 23 µm on the average between the four corners and the center of the wiring board 1. Except for this, the wiring board 1 was produced in the same manner as in Example 1.

### (Reference Example 1)

In the step of Figure 5D and the step of Figure 5E, electrolytic copper plating having a thickness of 10 µm was formed on the entire surface of the base member 8 including the inside of the laser hole 21, and the thickness of the conductor pattern 2 formed on the surface of the base member 8 was about 13 µm on the average between the four corners and the center of the wiring board 1. In addition, in the step of Figure 6G, the thicknesses of the conductor pattern 2 and the reflection member 4 in the vicinity thereof after the polishing were both about 8 µm on the average between the four corners and the center of the wiring board 1. Except for this, the wiring board 1 was produced in the same manner as in Example 1.

### (Comparative Example 2)

In the step of Figure 6F, the liquid reflection member 4 was applied by printing to the entire surface of the base member 8 including the conductor pattern 2. The reflection member A was used as the liquid reflection member 4. Next, the reflection member 4 was formed on the entire surface of the base member 8 including the conductor pattern 2 by heating and curing for 2 hours at 150°C in a hot air circulation furnace. Next, in the step of Figure 6G, the surface of the reflection member 4 was not polished but left as it is after being heated and cured. Therefore, the reflection member 4 was formed on the entire surface of the base member 8 including the conductor pattern 2, and the conductor pattern 2 was not exposed. In addition, the thickness of the conductor pattern 2 was about 23 µm on the average between the four corners and the center of the wiring board 1, and the thickness of the reflection member 4 in the vicinity thereof was about 24 µm on the average between the four corners and the center of the wiring board 1. Except for this, the wiring board 1 was produced in the same manner as in Example 1.

### (Example 10)

In the step of Figure 6G, at the time of performing the mechanical polishing using buff rolls on the surface of the reflection member 4, #600, #800, #1000, #1500, and #2000 were used as the buff rolls in the stated order. The thicknesses of the conductor pattern 2 and the reflection member 4 in the vicinity thereof after the polishing were both about 18 µm on the average between the four corners and the center of the wiring board 1. Except for this, the wiring board 1 was produced in the same manner as in Example 1.

### (Example 11)

As illustrated in Figure 8F to Figure 8I, the conductor pattern 26 which was to be subjected to laser irradiation was provided in the inner wiring layer 22 on the base member 16 for the inner layer, and the window hole 25 was formed in the wiring layer 14 on the base member 8 at a position at which the concave part 24 opened upward was to be provided. Then, according to the conformal technique, the concave part 24 which passes through the reflection member 4 and the base member 8 to reach the conductor pattern 26 was formed by using a laser beam machine. Except for this, the wiring board 1 was produced in the same manner as in Example 1.

With regard to the wiring board thus produced according to each of Examples 1 to 11, Reference Example 1, and Comparative Examples 1 and 2, the thickness of the reflection member, the surface roughness of the reflection member, the reflection rate of the reflection member, and the reflection rate of the reflection layer were measured.

### (Measurement of the thickness of the reflection member)

For the thicknesses of the conductor pattern and the reflection member in the vicinity thereof, the cross section was observed for the measurement, and an average value of five points at the four corners and the center of the wiring board was obtained.

### (Measurement of the surface roughness)

The surface roughness is an average roughness Ra which is defined by JIS C 6481, and was measured by using stylus-type surface roughness measuring machine Surftest SV-400 (product name, produced by Mitutoyo Corporation).

### (Measurement of the reflection rate)

The reflection rates of the reflection member and the reflection layer were measured by using a spectrophotometer (product name: CM-508d, produced by Minolta Co., Ltd.) with regard to a wavelength range including 420 ± 10 nm to 800 ± 10 nm. In addition, the reflection rates at wavelengths of 420 ± 10 nm, 460 ± 10 nm, 550 ± 10 nm, 660 ± 10 nm, and 800 ± 10 nm were read from the measurement results (in Table 1, the respective wavelengths are expressed as 420, 460, 550, 660, and 800).

### (Adhesion strength of the sealing member)

An epoxy resin composition for sealing was formed into a columnar shape (a diameter of 3.6 mm) on the board on which the reflection member was formed, and the adhesion strength thereof was measured by using Bondtester produced by Dage Precision Industries.

With regard to the wiring board according to each of Examples 1 to 11, Reference Example 1, and Comparative Examples 1 and 2, the measurement results of the thickness of the reflection member, the surface roughness of the reflection member, the reflection rate of the reflection member, the reflection rate of the reflection layer, and the adhesion strength of the sealing member are shown in Table 1. With regard to Examples 1, 2, and 7, the reflection rates at wavelengths of 420 ± 10 nm, 460 ± 10 nm, 550 ± 10 nm, 660 ± 10 nm, and 800 ± 10 nm are shown. With regard to the examples and comparative examples other than Examples 1, 2, and 7, the relation between the wavelength and the reflection rate exhibited a similar tendency, and hence the reflection rate at a wavelength of 460 ± 10 nm is shown as a representative value. The results of Examples 1 to 11 and Comparative Example 1 show that the reflection rate is significantly improved by providing the reflection member on the base member, compared with the case where only the base member is provided (Comparative Example 1). The results of Examples 1 to 7 and Reference Example 1 show that, if the thickness of the reflection member is equal to or larger than approximately 10 µm, it is possible to obtain a high reflection rate of 70% or higher with respect to light within the entire wavelength range between 420 ± 10 nm and 800 ± 10 nm. In addition, comparing Examples 1, 5, 6, and 10 (in all of which the polishing was performed) with Comparative Example 2 (in which the polishing was not performed and the conductor pattern was not exposed), a difference in reflection rate therebetween is approximately 3% at the maximum, and the results of Examples 1, 5, 6, and 10 show that, even if the surface roughness of the reflection member changes between approximately 0.3 and 7 µm in Ra, the reflection rate holds an equivalent value. The results of Examples 1 and 7 show that, even if plating of the reflection layer is changed from electrolytic silver to electrolytic gold, it is possible to obtain a high reflection rate of 70% or higher with respect to light within the entire wavelength range between 420 ± 10 nm and 800 ± 10 nm.

Table 1 shows the measurement results of the thickness of the reflection member, the surface roughness of the reflection member, the reflection rate of the reflection member, the reflection rate of the reflection layer, and the adhesion strength of the sealing member with regard to the wiring board according to each of Examples 1 to 11, Reference Example 1, and Comparative Examples 1 and 2.

**[Table 1]**

| Example No. | Measurement Reflection Wavelength (nm) | Member | Thickness of Reflection Member (µm) | Surface Roughness of Reflection Member (µm) | Reflection Rate of Reflection Member (%) | Plating of Reflection Layer | Reflection Strength Rate of Reflection Sealing Layer(%) | Adhesion of Member (MPa) |
|---|---|---|---|---|---|---|---|---|
| Example 1 | 420 | Resin A | 18 | 1.6 - 3 | 90 | Electrolytic Silver | 97 | 3.88 |
| | 460 | | | | 89 | | 98 | |
| | 550 | | | | 87 | | 99 | |
| | 660 | | | | 86 | | 100 | |
| | 800 | | | | 84 | | 100 | |
| Example 2 | 420 | ResinA | 14 | 1.6 - 3 | 85 | Electrolytic Silver | 97 | - |
| | 460 | | | | 84 | | 98 | |
| | 550 | | | | 83 | | 99 | |
| | 660 | | | | 81 | | 100 | |
| | 800 | | | | 80 | | 100 | |
| Example 3 | 460 | Resin A | 28 | 1.6 - 3 | 90 | Electrolytic Silver | 98 | - |
| Example 4 | 460 | Resin A | 47 | 1.6 - 3 | 89 | Electrolytic Silver | 98 | - |
| Example 5 | 460 | Resin A | 18 | 0.5 - 1 | 92 | Electrolytic Silver | 99 | 3.21 |
| Example 6 | 460 | Resin A | 20 | 5 - 7 | 90 | Electrolytic Silver | 98 | 5.02 |
| Example 7 | 420 | Resin A | 20 | 1.6 - 3 | 91 | Electrolytic Gold | 70 | - |
| | 460 | | | | 90 | | 71 | |
| | 550 | | | | 88 | | 71 | |
| | 660 | | | | 86 | | 72 | |
| | 800 | | | | 84 | | 73 | |
| Example 8 | 460 | Resin B | 18 | 1.6 - 3 | 91 | Electrolytic Silver | 98 | 3.79 |
| Example 9 | 460 | Resin C | 21 | 1.6 - 3 | 91 | Electrolytic Silver | 98 | 4.12 |
| Comparative Example 1 | 460 | - | 0 | - | 30 | Electrolytic Silver | 98 | - |
| Reference Example 1 | 460 | Resin A | 8 | 1.6 - 3 | 69 | Electrolytic Silver | 98 | - |
| Comparative Example 2 | 460 | Resin A 24 | | 0.1 - 0.2 | 92 | - | - | 1.87 |
| Example 10 | 460 | Resin A | 18 | 0.3 - 0.5 | 92 | Electrolytic Silver | 97 | 3.01 |
| Example 11 | 460 | Resin A | 18 | 1.6 - 3 | 90 | Electrolytic Silver | 95 | 5.48 |

### Reference Signs List

1 ... wiring board, 2 ... conductor pattern, 3 ... conductor pattern gap, 4 ... reflection member, 5 ... mounting electrode, 6 ... intermediary electrode, 7 ... reflection layer, 8 ... base member, 9 ... electronic device, 10 ... sealing member, 11 ... electronic device package, 12 ... white pigment, 13 ... frame-like conductor, 14 ... wiring layer, 15 ... interlayer connection, 16 ... base member (for inner layer), 17 ... interlayer connection (of inner layer), 18 ... through hole, 19 ... copper foil (of inner layer), 20 ... window hole, 21 ... laser hole, 22 ... wiring layer (of inner layer), 23 ... copper foil, 24 ... concave part opened upward, 25 ... window hole, 26 ... conductor pattern (of inner layer)

## Claims

1. A wiring board, comprising:
a plurality of wiring layers each including a conductor pattern provided on a base member; and
the base member which electrically insulates the plurality of wiring layers, wherein:
the wiring board further comprises a reflection member which is formed on a portion of the base member in which the conductor pattern is not provided, in an outermost wiring layer among the plurality of wiring layers;
a surface of the reflection member and a surface of the conductor pattern are made level with each other; and
the surface of the conductor pattern is exposed from the reflection member.

2. The wiring board according to Claim 1, wherein:
the conductor pattern includes:
an electrode for mounting an electronic device thereon; and
a frame-like conductor which surrounds the electrode;
the reflection member is formed on the portion of the base member in which the conductor pattern is not provided so as to fill a gap between the conductor patterns, inside of the frame-like conductor;
the surface of the reflection member and the surface of the conductor pattern are made level with each other; and
the surface of the conductor pattern is exposed from the reflection member.

3. The wiring board according to Claim 1 or 2, wherein the conductor pattern and the reflection member are collectively polished after the reflection member is formed on the portion of the base member in which the conductor pattern is not provided, to thereby make the surface of the reflection member and the surface of the conductor pattern level with each other and expose the surface of the conductor pattern on the reflection member.

4. The wiring board according to Claim 1 or 2, wherein the reflection member is a resin composition containing a heat-curable resin and a white pigment.

5. The wiring board according to Claim 1 or 2, wherein a thickness of the reflection member is 10 µm to 50 µm.

6. The wiring board according to Claim 1 or 2, further comprising a reflection layer which is formed by gold plating or silver plating on the conductor pattern.

7. The wiring board according to Claim 1 or 2, wherein both of the conductor pattern and the reflection member have a reflection rate of 70% or higher with respect to light having any wavelength between 420 ± 10 nm and 800 ± 10 nm.

8. The wiring board according to Claim 1 or 2, wherein the surface of the reflection member includes irregularities of 0.3 µm to 7 µm in terms of an average roughness Ra.

9. The wiring board according to Claim 1 or 2, further comprising a concave part opened upward which is provided in the reflection member of the outermost wiring layer.

10. An electronic device package, which is formed by: using the wiring board according to Claim 1 or 2; mounting an electronic device on an electrode formed in a conductor pattern; and sealing the electrode and the electronic device with a sealing member.

11. A method of production of a wiring board, comprising the steps of:
forming a conductor pattern in an outermost wiring layer among a plurality of wiring layers, the conductor pattern including:
an electrode for mounting an electronic device thereon; and
a frame-like conductor which surrounds the electrode;
forming a reflection member on a portion of a base member in which the conductor pattern is not provided so as to fill a gap between the conductor patterns; and
collectively polishing the conductor pattern and the reflection member, to thereby make a surface of the reflection member and a surface of the conductor pattern level with each other and expose the surface of the conductor pattern on the reflection member.

12. The method of production of the wiring board according to Claim 11, further comprising the step of forming a concave part opened upward in the reflection member.

13. A method of production of an electronic device package, comprising the steps of:
forming a conductor pattern in an outermost wiring layer among a plurality of wiring layers, the conductor pattern including:
an electrode for mounting an electronic device thereon; and
a frame-like conductor which surrounds the electrode;
forming a reflection member on a portion of a base member in which the conductor pattern is not provided so as to fill a gap between the conductor patterns;
collectively polishing the conductor pattern and the reflection member, to thereby make a surface of the reflection member and a surface of the conductor pattern level with each other and expose the surface of the conductor pattern on the reflection member; and
mounting the electronic device on the electrode of the conductor pattern and sealing the conductor pattern and the electronic device with a sealing member.

14. The method of production of the electronic device package according to Claim 13, further comprising, after the step of collectively polishing the conductor pattern and the reflection member, to thereby make the surface of the reflection member and the surface of the conductor pattern level with each other and expose the surface of the conductor pattern on the reflection member, the steps of:
forming a concave part opened upward in the reflection member; and
mounting the electronic device on the electrode of the conductor pattern and sealing the conductor pattern and the electronic device with the sealing member.
